(19) Europäisches Patentamt / European Patent Office / Office européen des brevets

(11) **EP 3 037 461 A1**

(12) **EUROPEAN PATENT APPLICATION**

(43) Date of publication:
**29.06.2016 Bulletin 2016/26**

(51) Int Cl.:
*C08J 5/04* (2006.01)    *C08J 5/10* (2006.01)
*C08J 5/24* (2006.01)    *C08L 63/00* (2006.01)
*H05K 1/03* (2006.01)

(21) Application number: **16151525.9**

(22) Date of filing: **30.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **17.07.2008 US 81449**

(62) Document number(s) of the earlier application(s) in accordance with Art. 76 EPC:
**09790004.7 / 2 303 953**

(71) Applicant: **Blue Cube IP LLC**
**Midland MI 48674 (US)**

(72) Inventors:
• **Turakhia, Rajesh**
**Lake Jackson, TX Texas 77566 (US)**
• **Verghese, Nikhil**
**Lake Jackson, TX Texas 77566 (US)**
• **Pham, Ha**
**Lake Jackson, TX Texas 77566 (US)**
• **Jacob, George**
**Lake Jackson, TX Texas 77566 (US)**

(74) Representative: **Bumke, Jakob Wenzel**
**Greaves Brewster LLP**
**Copa House**
**Station Road**
**Cheddar BS27 3AH (GB)**

Remarks:
This application was filed on 15-01-2016 as a divisional application to the application mentioned under INID code 62.

(54) **STRUCTURAL COMPOSITES WITH IMPROVED TOUGHNESS**

(57)    A structural composite comprising (i) a carbon fiber reinforcing material and (ii) a thermosettable resin composition; wherein the thermosettable resin composition comprises: a) thermosettable resin, and b) at least one amphiphilic block copolymer toughening agent comprising a polyether triblock copolymer; wherein the block copolymer toughening agent is a second-phase toughening agent, which self assembles into a second phase domain in the host thermosettable resin to improve its toughness; wherein the average Mode I strain energy release rate of the structural composite is from 200 J/m$^2$ to 1500 J/m$^2$ as measured according to ASTM D-5528-01, and wherein the glass transitional temperature ($T_g$) of the structural composite is from 70°C to 300°C as measured by Dynamic Mechanical Analysis.

FIG. 1

EP 3 037 461 A1

**Description**

BACKGROUND OF THE INVENTION

Field of the Invention

The present invention relates to structural composites with improved toughness. More particularly, the present invention relates to structural composites using block copolymer toughening agents to increase the fracture toughness of the structural composites.

Description of Background and Related Art

Structural composites are known to be useful for many applications such as electrical, aerospace, transportation and outdoor sports equipments applications. Thermosettable resins such as epoxy resins are commonly used as the polymer matrix in the structural composites. The epoxy resins are usually used with reinforcing materials such as glass fibers to form the structural composites. The combination of the epoxy resins and the reinforcing materials may be cured with hardeners or curing agents. The cured or thermoset epoxy resins are known for their good thermal, mechanical, and chemical properties but they lack toughness and tend to be brittle upon cure.

In addition, the epoxy resins and some other thermosettable resins in general are known to be very difficult to toughen and some may be too brittle to toughen effectively. Attempts to increase the fracture toughness of the brittle thermosettable resins in the past often came at the expense of changes (typically reduction) of modulus and thermal properties (e.g. glass transition temperature; Tg) of the resulting thermoset resins, creating unacceptable limits on the applicability of the thermoset resins. For example, high molecular weight viscous rubbers such as carboxyl-terminated butadiene-acrylonitrile (CTBN) rubber or core shell rubber have been used as toughening agents to improve toughness of epoxy resins, however, the improvement in toughness usually leads to a higher loading of the toughening agents, a higher viscosity, and/or a drop in glass transition temperature (Tg) of the epoxy resins.

Accordingly, there is a need in the industry to develop a thermosettable resin composition for making structural composites with improved ductility (i.e. fracture toughness) while still maintaining other key processing (e.g. viscosity) and performance (e.g. glass transition temperature and modulus) properties.

SUMMARY OF THE INVENTION

The present invention provides a structural composite which shows improvement in fracture toughness while still maintaining its other key processing properties (e.g. viscosity) and performance (e.g. modulus and glass transition temperature).

One aspect of the present invention is directed to a structural composite, which comprises (i) a reinforcing material such as carbon fiber, and (ii) a thermosettable resin composition; wherein the thermosettable resin composition comprises (a) a thermosettable resin, and (b) at least one block copolymer toughening agent.

Another aspect of the present invention is directed to a process of preparing the structural composite, which comprises (1) partially curing a thermosettable resin composition to form an advanced thermosettable resin; (2) impregnating a carbon reinforcing material with the advanced thermosettable resin to form a prepreg; and (3) completely curing the prepreg to form the structural composite.

BRIEF DESCRIPTION OF THE DRAWINGS

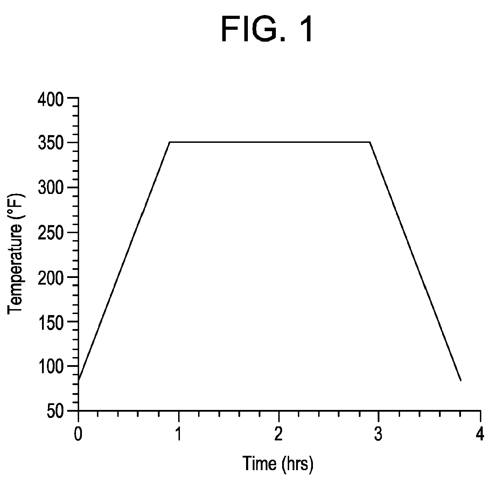

Figure 1 is a graphical illustration showing a cure profile for epoxy resins of the present invention.

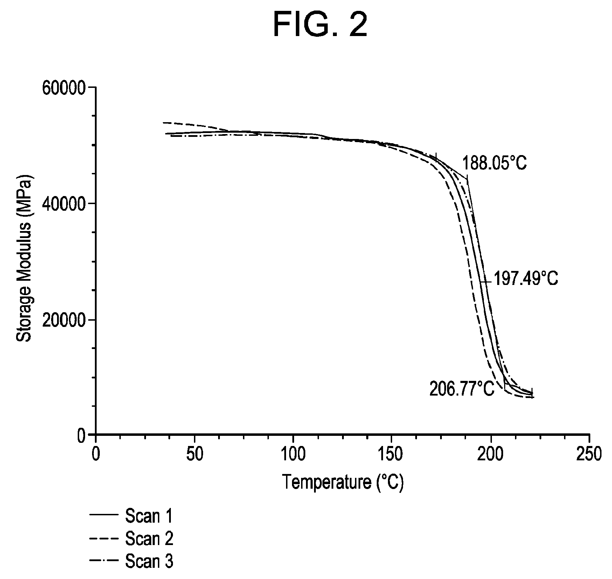

Figure 2 is a graphical illustration showing Dynamic Mechanical Analysis (DMA) results for a carbon fiber reinforced composite F1 (Control) without using a block copolymer toughening agent of the present invention. The DMA results (3 scans), illustrated in Figure 2, for carbon fiber F1 sample (Control) indicates a Tg of about 193°C and shear modulus of about 55000 MPa at 40°C.

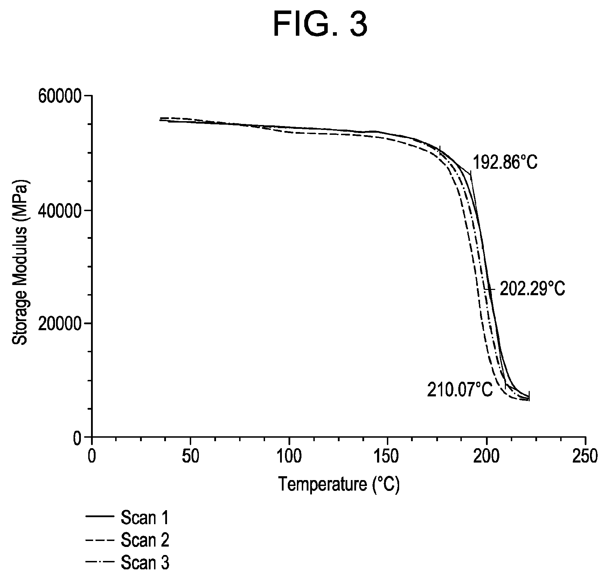

Figure 3 is a graphical illustration showing Dynamic Mechanical Analysis (DMA) results for a carbon fiber reinforced composite F2 (Toughened) using a block copolymer toughening agent of the present invention. The DMA results (3 scans), illustrated in Figure 3, for carbon fiber F2 sample (Toughened) indicates a Tg of about 195°C and a shear modulus of 55000 MPa at 40°C.

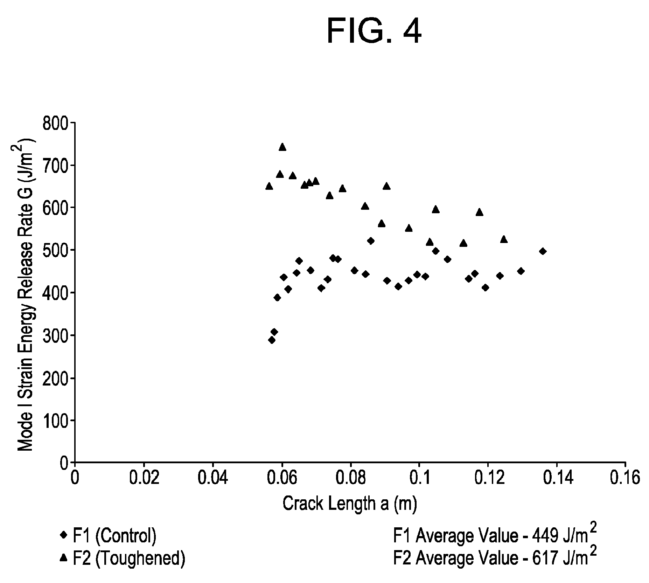

Figure 4 is a graphical illustration showing Mode I strain energy release rate ($G_{1c}$) results for a carbon fiber reinforced composite F1 (Control) without using a block copolymer toughening agent; and for a carbon fiber reinforced composite F2 (Toughened) using a block copolymer toughening agent of the present invention. The mode I strain energy release rate , illustrated in Figure 4, was computed using Modified Beam Theory.

DETAILED DESCRIPTION OF THE INVENTION

As noted above, the present invention provides a structural composite comprising (i) a reinforcing material such as carbon fiber, and (ii) a thermosettable resin composition; wherein the thermosettable resin composition comprises (a) a thermosettable resin, and (b) at least one block copolymer toughening agent.

Examples of the reinforcing materials which are suitable for the formation of structural composites of the present invention may include one or more of fibers such as carbon; graphite; boron, quartz; aluminum oxide; aramid; glass such as E glass, S glass, S-2 glass or C glass; and silicon carbide or silicon carbide fibers containing titanium; and mixtures thereof. Commercially available fibers may include: organic fibers such as KEVLAR™ from DuPont; aluminum oxide-containing fibers, such as NEXTEL™ fibers from 3M; silicon carbide fibers, such as NICALON™ from Nippon Carbon; and silicon carbide fibers containing titanium, such as TYRRANO™ from Ube; or a combination of glass and carbon fibers (hybrids); and mixtures thereof.

More preferred examples of the reinforcing materials useful in the present invention may be carbon fibers or fibers comprising carbon in combination with other materials such as glass. Carbon fibers generally are supplied in a number of different forms, such as for example continuous filament tows, chopped fibers and mats. The fibers can be unidirectional or multidirectional. The tows of continuous filament carbon generally contain from about 1,000 to about 75,000 individual filaments, which can be woven or knitted into woven roving and hybrid fabrics with glass fibers and aramid fibers. The carbon fiber reinforcing materials useful for the structural composite of the present invention may be in the forms of, for example, woven fabric, cloth, mesh, web, or fibers; or in the form of a cross-ply laminate of unidirectionally oriented parallel filaments.

The amount fibers useful in the present invention is generally from about 10 % to about 90 % fibers volume fraction; preferably from about 50 % to about 75 % fibers volume fraction; and more preferably from about 60 % to about 70 % fibers volume fraction.

The term "thermosettable" as used herein means that the composition is capable of being subjected to conditions which will render the composition to a cured or thermoset state or condition.

The term "thermoset" is defined by L. R. Whittington in Whittington's Dictionary of Plastics (1968) on page 239 as follows: "Resin or plastics compounds which in their final state as finished articles are substantially infusible and insoluble. Thermosetting resins are often liquid at some stage in their manufacture or processing, which are cured by heat, catalysis, or some other chemical means. After being fully cured, thermosets cannot be resoftened by heat. Some plastics which are normally thermoplastic can be made thermosetting by means of crosslinking with other materials."

The thermosettable resin composition of the present invention comprises (a) a thermosettable resin, and (b) a block copolymer toughening agent. The thermosettable resin composition may also optionally comprise one or more of the following components: (c) a curing agent, (d) a catalyst, and (e) other additives.

Examples of the thermosettable resins suitable for the present invention may include epoxy resins; dicyclopentadiene phenol novolac resins: trifunctional resins based on p-amino phenol and m-amino phenol; tri- and tetra-functional resin based on methylene dianiline (MDA); vinyl esters; cyanate esters; polyesters; and any mixture thereof.

The epoxy resin may be any polyepoxide compound which possesses more than one vicinyl epoxy group per molecule, i.e. more than one 1,2-epoxy group per molecule.

Examples of the epoxy resins useful in the present invention may include glycidyl polyethers of polyhydric phenols and polyhydric alcohols. As an illustration of the present invention, examples of the epoxy resins that may be used in the present invention include diglycidyl ethers of resorcinol, catechol, hydroquinone, bisphenol, bisphenol A, bisphenol AP (1,1-bis(4-hydroxylphenyl)-1-phenyl ethane), bisphenol F, bisphenol K, tetrabromobisphenol A, phenol-formaldehyde novolac resins, alkyl substituted phenolformaldehyde resins, phenol-hydroxybenzaldehyde resins, cresol-hydroxybenzaldehyde resins, dicyclopentadiene-phenol resins, dicyclopentadiene-substituted phenol resins tetramethylbiphenol, tetramethyl-tetrabromobiphenol, tetramethyltribromobiphenol, tetrachlorobisphenol A, and any combination thereof.

More preferred examples of the epoxy resin may include diglycidyl ethers of bispehnol A and bisphenol F; cycloaliphatic epoxies; epoxy novolac resins; epoxy cresol novolac resins, such as isocyanate modified epoxy resins; and other multifunctional epoxies.

The amount the thermosettable resin of the thermosettable resin composition useful in the present invention is generally from about 10 % to about 95 % resin volume fraction; preferably from about 25 % to about 50 % resin volume fraction; and more preferably from about 30 % to about 40 % resin volume fraction.

The viscosity of the thermosettable resin of the present invention is generally from about 50 centipoise to about 300000 centipoise; preferably from about 100 centipoise to about 150000 centipoise; and most preferably from about 100 centipoise to about 15000 centipoise.

The block copolymer toughening agent of the present invention may be a second-phase toughening agent, which self assembles into a second phase domain in the host thermosettable resin to improve its toughness. The self-assembled thermosettable resins comprising the block copolymer toughening agent exhibit surfactant-like morphologies which provide enhanced fracture toughness at very low (for example, from about 1 percent to about 5 percent by weight based on the total weight of the thermosettable resin) block copolymer loadings.

The "second phase" means a distinct and different physical phase from the other phase of the host thermosettable resin. Because the modification is limited to a second phase, only lower levels of the block copolymer are needed to achieve the desired level of toughness.

In general, the effective quantity of the block copolymer as the toughening agent in the present invention may be in the range of from about 0.1 percent to about 50 percent by weight; preferably, from about 2.5 percent to about 30 percent by weight; and more preferably, from about 5 percent to about 10 percent by weight based on the total weight of the thermosettable resin.

In a preferred embodiment, the block copolymer comprises an ampiphilic block copolymer. The amphiphilic block copolymers which can be employed in the present invention may include, for example, a diblock copolymer, a linear triblock, a linear tetrablock, a higher order multiblock structure, a branched block structure, or star block structure. Preferably, the amphiphilic block copolymer may be a polyether block copolymer. The polyether block copolymer may comprises, for example, a polyethylene oxide block, propylene oxide block or poly(ethylene oxide-co-propylene oxide) block; and an alkylene oxide block based on a $C_4$ or higher carbon analog block, such as 1,2-epoxybutane, 1,2-epoxyhexane, 1,2-epoxydodecane, or 1,2-epoxyhexadecane block.

More preferred examples of suitable amphiphilic block copolymers useful in the present invention include amphiphilic polyether diblock copolymers such as, for example, polyethylene oxide)-b-poly(butylene oxide)(PEO-PBO) or amphiphilic polyether triblock copolymers such as, for example, poly(ethylene oxide)-b-poly(butylene oxide)-b-poly(ethylene oxide) (PEO-PBO-PEO).

The block copolymer toughening agent of the present invention may comprise at least one or more amphiphilic block copolymers. Two or more different amphiphilic block copolymers may be blended together to make up the block copolymer component of the present invention. In general, one block is a thermosettable resin miscible block and one block is a thermosettable resin immiscible block.

Examples of the thermoset resin miscible block, E, includes a polyethylene oxide block, a propylene oxide block, a poly(ethylene oxide-co-propylene oxide) block, a poly(ethylene oxide-ran-propylene oxide) block, and mixtures thereof. Generally, the thermosettable resin immiscible block, M, useful in the present invention is an epoxidized alpha olefin having carbon atoms of from $C_4$ to $C_{20}$. Examples of the thermosettable resin immiscible block, M, include a polybutylene oxide block, a polyhexylene oxide block derived from 1,2 epoxy hexane, a polydodecylene oxide block derived from 1,2-epoxy dodecane, and mixtures thereof. Preferably, the resin immiscible block useful in the present invention is a polybutylene oxide block.

The amphiphilic block copolymer used in the present invention may have a number average molecular weight (Mn) of from about 1,000 to about 30,000, for the combination of both thermosettable resin block and thermosettable resin immiscible block. Most preferably, the molecular weight of a polyether block copolymer is between about 3,000 and about 20,000.

In a more preferred embodiment, the present invention utilizes amphiphilic block copolymers containing an epoxy resin miscible block and an epoxy resin immiscible block.

Examples of the epoxy resin immiscible block of the block copolymer include polyethylene propylene (PEP), polybutadiene, polyisoprene, polydimethyl siloxane polybutylene oxide, polyhexylene oxide, polyalkyl methyl methacrylate, such as polyethyl hexyl methacrylate, and mixtures thereof. Examples of the epoxy resin miscible block of the block copolymer include polyethylene oxide, polymethyl acrylate, and mixtures thereof.

In another embodiment of the present invention, when the block copolymer has a multiblock copolymer structure, other blocks in addition to E and M may be present in the block copolymer. Examples of other miscible blocks of the block copolymer include polyethylene oxide, polymethyl acrylate, and mixtures thereof. Examples of other immiscible blocks of the block copolymer include polyethylene propylene (PEP), polybutadiene, polyisoprene, polydimethyl siloxane, polybutylene oxide, polyhexylene oxide, polyalkyl methyl methacrylate, such as polyethyl hexyl methacrylate, and mixtures thereof.

In general, the block copolymers used in the present invention may be prepared in a single sequential synthetic polymerization process, wherein one monomer is polymerized to prepare an initial block, followed by simple introduction of the second monomer type which is then polymerized onto the terminus of the first block copolymer until the polymerization process is complete. It is also possible to make the blocks separately, preparing the first block and then polymerizing the second block onto the terminus of the first block in a second synthetic step. The difference in solubility of the two block fragments is sufficient that the block copolymer may be used to modify the thermosettable resins. The synthesis of the block copolymer may be carried out, for example, as described in Whitmarsh, R. H., In Nonionic Surfactants Polyoxyalkylene Block Copolymers; Nace, V. M., Ed.; Surfactant Science Series; Vol. 60; Marcel Dekker, N.Y., 1996; Chapter 1, which is incorporated herein by reference.

The block copolymer toughening agent used in the present inventions increases the fracture resistance, thus improves the fracture toughness, of the thermosettable resin. For example, the increase in fracture resistance in the thermosettable epoxy resin can be greater than 5 times, preferably greater than 10 times, and more preferably, up to 50 times.

The amount the block copolymer toughening agent useful in the thermosettable composition of the present invention is generally from about 0.1 wt% to about 50 wt% based on the total weight of the thermosettable resin; preferably from about 2.5 wt% to about 30 wt% based on the total weight of the thermosettable resin; and more preferably from about 5 wt% to about 10 wt% based on the total weight of the thermosettable resin.

The thermosettable resin composition may also optionally comprise one or more of the following components: (c) a curing agent, (d) a catalyst, and (e) one or more other additives.

The curing agent which is useful in the present may be any compound having an active group which is reactive with the epoxide group of the epoxy resin. The curing agent useful in the present invention includes nitrogen-containing compounds such as amines and their derivatives; oxygen-containing compounds such as carboxylic acid terminated polyesters, anhydrides, phenol-formaldehyde resins, amino-formaldehyde resins, phenol, bisphenol A and cresol novolacs, phenolic-terminated epoxy resins; sulfur-containing compounds such as polysulfides, polymercaptans; and catalytic curing agents such tertiary amines, Lewis acids, Lewis bases and combinations of those curing agents. Preferably, polyamines, dicyandiamide, diaminodiphenylsulfone and their isomers, aminobenzoates, various acid anhydrides, phenol-novolac resins and cresol-novolac resins, for example, may be used in the present invention, but the present invention is not restricted to the use of these compounds.

Any of the well-known catalysts described in U.S. Patent. No. 4,925,901, incorporated herein by reference, may be used in the present invention. As an illustration, examples of the known catalysts that may be used in the present invention include, for example, suitable onium or amine compounds such as ethyltriphenyl phosphonium acetate, ethyltriphenyl phosphonium acetate-acetic acid complex, triethylamine, methyl diethanolamine, benzyldimethylamine, and imidazole compounds such as 2-methylimidazole and benzimidazole; and any combination thereof.

The catalysts, when present, are employed in a sufficient amount to result in a substantially complete cure of the thermosettable resin, with some cross-linking. For example, the catalyst may be used in an amount of from about 0.01 to about 5 parts per hundred parts of resin (phr); preferably, from about 0.01 to about 1.0 phr; and more preferably, form about 0.02 phr to about 0.5 phr.

Concentrations of components used in the thermosettable resin composition of present invention are measured as parts by weight of components per hundred parts of resin by weight (phr), unless otherwise noted. The "resin" in the "phr" refers to the total weight of the thermosettable resin in the thermosettable resin composition.

The thermosettable resin composition according to the present invention may optionally contain other additives such as fillers, dyes, pigments, thixotropic agents, surfactants, fluidity control agents, stabilizers, diluents that aid processing, adhesion promoters, flexibilizers, toughening agents, fire retardants, and mixtures thereof.

The amount of the optional additives used in the thermosettable resin composition generally may be from about 0 wt% to about 70 wt%; preferably from about 0.01 wt% to about 70 wt%; and more preferably, from about 5 wt% to about 20 wt% depending on the final end use application.

The structural composite of the present invention may be made by techniques such as impregnating the reinforcing material (e.g. a carbon fiber) with molten or dissolved thermosettable resin (e.g. an epoxy resin), or via resin transfer molding (RTM) including vacuum assisted resin transfer molding (VARTM); open molding such as hand layup or sprayup; filament winding; pultrusion molding; reaction injection molding (RIM); and other moulding, encapsulation, or coating techniques.

In a preferred embodiment of the present invention, the structural composite of the present invention may be prepared by (1) partially curing a thermosettable resin composition to form an advanced thermosettable resin; (2) impregnating a carbon reinforcing material with the advanced thermosettable resin to form a prepreg (3) and completely curing the prepreg to form the structural composite.

The thermosettable resin composition, as stated above, comprise (a) a thermosettable resin, (b) a block copolymer toughening agent, (c) a curing agent, (d) a catalyst, and optionally, (e) an additive. The thermosettable resin composition of the present invention may be employed in the form of, for example, an adhesive, a coating, a molding resin, an embedding resin, an encapsulating resin, a sheet molding compound, or a bulk molding compound.

The temperature used to cure the thermosettable resin composition depends upon the particular residence time, pressure used, and the thermosettable resin used. Preferred curing temperatures which may be used are between about 50 °C and about 300 °C; more preferably, between about 120 °C and about 250 °C; and most preferably, between about 170 °C and about 200 °C. The residence times are preferably from about 10 minutes to about 120 minutes, and more preferably from about 20 minutes to about 90 minutes.

A reinforcing material impregnated with a partially cured resin is usually referred to herein as the "prepeg". One or more sheets of prepregs may be processed to form a laminate. Before being completely cured, the prepregs may be cut and stacked or folded and stacked into a part of desired shape and thickness.

The present invention provides structural composites which use the block copolymer toughening agents to enhance the toughness of the structural composite. The structural composite of the present invention has improved fracture toughness without adversely affecting other key properties of the structural composite.

It has been discovered in the present invention that the block copolymer toughening agent provides the following benefits to a structural composite compared to a conventional structural composite: (1) improve viscosity (lower in magnitude); (2) use low loading levels of the block copolymer toughening agent to achieve toughening results at low concentrations (for example, from about 1 percent to about 5 percent of the block copolymer toughening agent based on the total weight of the host thermosettable resin), thus at a lower cost and with minimal changes to current processing equipment; and (3) improve the toughness of the structural composite without adversely affecting other key properties such as modulus and glass transition temperature (Tg).

The Tg of the structural composite of the present invention is generally from about 70 °C to about 300 °C; preferably from about 140 °C to about 220 °C; and most preferably from about 170 °C to about 200 °C.

The Average Mode I strain energy release rate of the structural composite of the present invention is generally from about 200 $J/m^2$ to about 1500 $J/m^2$; preferably from about 250 $J/m^2$ to about 1500 $J/m^2$; and most preferably from about 250 $J/m^2$ to about 800 $J/m^2$.

As an illustration, the structural composite of the present invention has, for example, a reduction of viscosity of about 16 % (see Example 1), an average strain energy release rate ($G_{IC}$) of about 617 $J/m^2$ (an increase of about 37% - see Example 3), and maintains a similar glass transition temperature ($T_g$) range of about 190°C to about 200°C (see Example 2), when compared to a conventional structural composite without using the block copolymer toughening agent of the present invention.

The composition of the present invention has remarkably improved fracture toughness. Fracture toughness is a quantitative way of expressing a material's resistance to brittle fracture when a crack is present. The fracture toughness is usually represented by the strain energy release rate, $G_{IC}$, which is calculated using linear elastic fracture mechanics (see Example 3). The subscript "IC" denotes mode I crack opening under a normal tensile stress perpendicular to the crack. As shown in Figure 4, the Mode I strain energy release rate ($G_{IC}$) for the composite laminate using the block copolymer toughening agent of the present invention is much higher than that of the composite laminate without using the block copolymer toughening agent.

The structural composites of the present invention may be useful in many applications. Applications of the structural composites may include use in electrical laminates structures for the aerospace industry; as circuit boards and the like for the electronics industry; for the formation of composites; pultruded composites; pultruded rods, skis, ski poles, fishing rods, and other outdoor sports equipment; filament wound pipe; and storage tanks.

The following Examples further illustrate the present invention in detail but are not to be construed to limit the scope thereof.

EXAMPLES

Various terms and designations used in the following examples are explained herein below:

D.E.R. ™ 383 is the trademark for a thermosetting epoxy resin which is commercially available from The Dow Chemical Company.

4-4' DDS stands for diamino-diphenyl sulphone, which is used as a curing agent in the following examples. The curing agent 4-4' DDS is a latent curing agent which has an onset active temperature (i.e. the temperature when the curing agent become active) of about 350 °F (177 °C). Accordingly, the curing agent provides a high degree of latency at room temperature (about 25°C) as well as a high degree of latency at a polymer filming temperature of about 165 °F (74 °C).

"gsm" stands for grams per square meter.

"phr" stands for per hundred parts of resin.

"cp" stands for centipoise.

"wt%" stands for weight percent.

F1 refers to a control formulation (D.E.R. ™ 383 and 4-4' DDS curing agent without using a toughening agent).

F2 refers to a formulation of the present invention (D.E.R. ™ 383 and 4-4' DDS curing agent with a block copolymer toughening agent of the present invention).

P1 refers to a control formulation (D.E.R. ™ 383 without using a toughening agent).

P2 refers to a formulation of the present invention (D.E.R. ™ 383 with a block copolymer toughening agent of the present invention).

P3 refers to a conventional formulation (D.E.R. ™ 383 with a conventional core shell rubber toughening agent).

Example 1 and Comparative Examples A and B

Part A. Thermosettable Resin Formulations Preparation

Formulation F1 comprises 100 parts of D.E.R. ™ 383 and 31.65 phr of 4-4' DDS curing agent.

Formulation F2 comprises 100 parts of D.E.R. ™ 383, 5 wt% of PEO-PBO-PEO triblock copolymer toughening agent, and 30.15 phr of 4-4' DDS curing agent.

Approximately 2600 grams of both formulations F1 and F2 were prepared. The components in both formulations F1 and F2 were mixed at room temperature (about 25 °C) and heated to 265 °F (129 °C). Under low shear mixing, both formulations F1 and F2 underwent an advanced reaction at 265 °F (129 °C) for 2 hours to form advanced resins A-F1 and A-F2, respectively. By heating the formulations F1 and F2 at 265 °F (129 °C), it provides the advanced resins A-F1 and A-F2 with an acceptable level of tack for later prepregging. These advanced resins A-F1 and A-F2 have sufficient tackiness (stickiness), which can be adhered to the carbon fiber reinforcing material during later prepregging.

Part B. Effect of Toughening Agents on Viscosity of Epoxy Resins

When a block copolymer toughening agent is added to D.E.R. ™ 383, it reduces the viscosity of the D.E.R. ™ 383, which makes later processing/fabrication of the structural composites much easier.
The following table shows the viscosities of the formulations P1 (100 parts of D.E.R. ™ 383), P2 (95 parts of D.E.R. ™ 383, 5 wt% of PEO-PBO-PEO triblock copolymer toughening agent), and P3 (95 parts of D.E.R. ™ 383, 5 wt% of coreshell rubber toughening agent).

| Example | Polymer Resins | Viscosity at 25 °C (cps) |
|---|---|---|
| Comparative Example A | P1 (D.E.R. ™ 383) | 10030 |
| Example 1 | P2 (D.E.R. ™ 383 + 5 wt. % block copolymer) | 8400 |
| Comparative Example B | P3 (D.E.R. ™ 383 + 5 wt% core shell rubber) | 13260 |

As shown in the above table, there is a 16% drop in the viscosity of the formulation P2 compared to the viscosity of the formulation P1 (control) without using any toughening agent under the same condition. This is in contrast to the formulation P3 which uses a conventional toughening agent such as a core shell rubber toughening agent. The viscosity of formulation P3 increases by more than 32% compared to the viscosity of the formulation P1 (control) without using any toughening agent.

Part C. Structural Composite Preparation

Filming Conditions

The advanced resins A-F1 and A-F2 prepared as described in Part A above were both filmed under the same conditions. A fixed roll-nip configuration was utilized, which has a fixed roll and a rotating roll. The temperature for both the fixed roll and the rotating roll were set at 165 °F (74 °C) (the 4-4' DDS curing agent has a high degree of latency at this temperature). Both advanced resins A-F1 and A-F were placed on metal trays and the metal trays were placed in an oven at 150 °F (66 °C) to form resin film F1 and resin film F2, respectively.
The target resin areal weights for both resin film F1 and resin film F2 were 107.7 gsm. Since the carbon fabric weighed 200 gsm, a resin film with a resin areal weight of about 107.7 gsm would provide for a prepreg with a resin content of about 35%. The current standards for aerospace prepregs require a resin content tolerance of +/- 2%. That gave the resin film with a resin areal weight of about 107.7 gsm a window of between about 98.51 gsm and about 117.46 gsm.
In the following experiments, a gamma gauge was utilized for in-line monitoring of the resin film weights. Both advanced resins A-F1 and A-F2 were filmed onto a Wausau 78 pound calendared paper. The Wausau 78 pound calendared paper weight was zeroed out. The following resin films were produced:

(1) 184 square feet of resin film F1 at an average areal weight of 111 gsm; and.

(2) 150 square feet of resin film F2 at an average areal weight of 113.9 gsm.

Prepregging and Laminating

The carbon fabric that was selected for this example was woven by Sigmatex™ Inc. in Benicia CA. The fabric was a 2x2 twill of T800 6k at a fabric areal weight of 200 gsm. The resin film F1 and resin film F2 were transfer coated onto the carbon fabric at 150 °F (66 °C) to form prepreg F1 and prepreg F2, respectively. The average resin content for the prepreg F1 was 35.7 % while the average resin content for the prepreg F2 was 36.3 %.

Carbon fiber reinforced composite laminate F1 and carbon fiber reinforced composite laminate F2 were manufactured from the prepreg F1 and prepreg F2, respectively, by utilizing a no-bleed vacuum bag system under autoclave pressure according to the RS47 cure cycle illustrated in Figure 1. The RS-47 cure schedule is designed to meet the requirements of structural applications such as wing box, floor support beams, or bulkheads, requiring high strength and stiffness with environmental service temperatures of up to 260°F (127°C) or higher. The finished laminate F1 and finished laminate F2 were trimmed to appropriate size panels (24 inch (61 cm) by 12 inch (30.5 cm)) and then tested. The testing includes measuring the glass transition temperature (Tg), modulus, and fracture toughness (or strain energy release rates) of the laminates. The testing results are shown in Figures 2-4.

The Tgs and modulus of the laminate F1 and laminate F2 were measured by Dynamic Mechanical Analysis (DMA). As shown in Figure 2, the DMA results indicate an average Tg to be about 193 °C and an average modulus of about 55000 MPa at 40 °C after 3 scans for the laminate F1. The DMA results in Figure 3 indicates an average Tg of about 195 °C and an average modulus of about 55000 MPa at 40 °C after 3 scans for the laminate F2. Accordingly, the results show that both laminate F1 and laminate F2 have very similar Tgs and modulus properties.

Part D. Fracture Toughness Testing

The fracture toughness of the laminate F1 and laminate F2 was determined using Mode I Double Cantilever Beam (DCB) method. The laminate samples were of rectangular shape with nominal width of 1 inch (2.54 cm). The thickness of each sample was the same as the laminate panel thickness. The length was 12 inches (30.5 cm) with a pre-crack length of approximately 2.5 inches (6.4 cm). The laminate samples were loaded at loading rates according to the guidelines of ASTM D5528-01 for DCB (0.1 inches/minute or 0.25 cm/minute).

An Instron electro-mechanical test frame was used for testing the laminate sample. The crack end of the sample was fitted with piano hinges (adhesively bonded with epoxy DP420 by 3M). The free side of each hinge was secured in the test frame grips for loading the sample. Load (P), cross head displacement ($\delta$) and crack tip location (i.e. crack length a) were recorded. The data were analyzed using the Modified Beam Theory (MBT) (Equation 1) as given in ASTM D-5528-01:

$$G_{IC} = \frac{3P\delta}{2ab} \qquad \text{Equation 1}$$

Where b is the width of the sample.

More details on the test method can be obtained by referring to the aforementioned ASTM standard. The testing results are shown in Figure 4.

As shown in Figure 4, the Mode I strain energy release rate ($G_{IC}$) for the laminate F2 is much higher than that of the laminate F1.

The results shown in Figures 2-4 indicates that the toughened laminate F2 has improved toughness while still maintaining similar glass transition temperature Tg and modulus.

It will be obvious to persons skilled in the art that certain changes may be made in the compositions, composites, and processes described above without departing from the scope of the present invention. It is therefore intended that all matter herein disclosed be interpreted as illustrative only and not as limiting the scope of protection sought. Moreover, the compositions, composites, and processes of the present invention are not to be limited by the specific examples set forth above. Rather, these examples arc illustrative of the compositions, composites, and processes of the present invention.

CLAUSES

The following clauses define particular aspects and embodiments of the invention:

Clause 1. A structural composite comprising (i) a reinforcing fibre such as carbon fiber and (ii) a thermosettable resin composition; wherein the thermosettable resin composition comprises (a) a thermosettable resin and (b) at least one block copolymer toughening agent.

Clause 2. The composite according to clause 1, wherein the block copolymer toughening agent is a second-phase toughening agent.

Clause 3. The composite according to clause 2, wherein the block copolymer toughening agent comprises an amphiphilic block copolymer.

Clause 4. The composite according to clause 3, wherein the block copolymer toughening agent comprises a poly(ethylene oxide)-b-poly(butylene oxide)(PEO-PBO) diblock copolymer or a poly(ethylene oxide)-b-poly(butylene oxide)-b-poly(ethylene oxide) (PEO-PBO-PEO) triblock copolymer.

Clause 5. The composite according to clause 1, wherein the amount of the block copolymer toughening agent present in the thermosettable resin composition is from about 1 percent to about 20 percent by weight based on the total weight of the thermosettable resin.

Clause 6. The composite according to clause 1 where the composite can be the skin of a sandwich material. This is typically applied to both sides of a light weight core.

Clause 7. The composite according to clause 5, wherein the amount of the block copolymer toughening agent present in the thermosettable resin composition is from about 0.1 percent by weight to about 50 percent by weight based on the total weight of the thermosettable resin.

Clause 8. The composite according to clause 1, wherein the thermosettable resin comprises an epoxy resin, a vinyl ester, a cyanate ester, or a polyester.

Clause 9. The composite according to clause 1, wherein the thermosettable resin composition further comprises (c) a curing agent, (d) a catalyst, and optionally, (c) an additive.

Clause 10. The composite according to clause 1, wherein the glass transitional temperature (Tg) of the structural composite is from about 70°C to about 300°C.

Clause 11. The composite according to clause 1, wherein the structural composite comprises an average resin content of from about 10 % to about 95 % resin volume fraction.

Clause 12. The composite according to clause 1, wherein the average Mode I strain energy release rate of the structural composite is from about 200 J/m$^2$ to about 1500 J/m$^2$.

Clause 13. A process of preparing the structural composite according to clause 1.

Clause 14. The process according to clause 13 comprising (1) partially curing a thermosettable resin composition to form an advanced thermosettable resin; (2) impregnating a carbon reinforcing material with the advanced thermosettable resin to form a prepreg; and (3) completely curing the prepreg to form the structural composite.

Clause 15. The process according to clause 14, wherein the temperature for curing the thermosettable resin composition is from about 50°C to about 300°C.

**Claims**

1. A structural composite comprising (i) a carbon fiber reinforcing material and (ii) a thermosettable resin composition; wherein the thermosettable resin composition comprises:

a) a thermosettable resin, and

b) at least one amphiphilic block copolymer toughening agent comprising a polyether triblock copolymer; wherein the block copolymer toughening agent is a second-phase toughening agent, which self assembles into a second phase domain in the host thermosettable resin to improve its toughness;

wherein the average Mode I strain energy release rate of the structural composite is from 200 $J/m^2$ to 1500 $J/m^2$ as measured according to ASTM D-5528-01, and wherein the glass transitional temperature (Tg) of the structural composite is from 70°C to 300°C as measured by Dynamic Mechanical Analysis.

2. The composite according to claim 1, wherein the block copolymer toughening agent comprises a poly(ethylene oxide)-b-poly(butylene oxide)-b-poly(ethylene oxide) (PEO-PBO-PEO) triblock copolymer.

3. The composite according to claim 1 or claim 2, wherein the amount of the block copolymer toughening agent present in the thermosettable resin composition is from 0.1 percent by weight to 50 percent by weight based on the total weight of the thermosettable resin.

4. The composite according to any preceding claim where the composite is the skin of a sandwich material applied to both sides of a light weight core.

5. The composite according to any preceding claim, wherein the thermosettable resin comprises an epoxy resin, a vinyl ester, a cyanate ester, or a polyester.

6. The composite according to any preceding claim, wherein the thermosettable resin composition further comprises (c) a curing agent, (d) a catalyst, and optionally, (e) an additive.

7. The composite according to any preceding claim, wherein the structural composite comprises an average resin content of from 10 % to 95 % resin volume fraction.

8. The composite according to any preceding claim, wherein the structural composite comprises an average fiber content from 10% to 90% volume fraction.

9. The composite according to any preceding claim, wherein the amount of the catalyst present in the thermosettable resin composition is from 0.01 to about 5 parts per hundred parts of the resin (phr).

10. The composite according to any preceding claim, wherein the amount of optional additives in the thermosettable resin composition is from 0 wt% to 70 wt%.

# FIG. 1

# FIG. 2

# FIG. 3

FIG. 4

Europäisches
Patentamt

European
Patent Office

Office européen
des brevets

## EUROPEAN SEARCH REPORT

Application Number

EP 16 15 1525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/015305 A1 (BERGER ELISABETH J [US] ET AL) 17 January 2008 (2008-01-17) * paragraphs [0001], [0006] - [0022]; claims * | 1-10 | INV. C08J5/04 C08J5/10 C08J5/24 C08L63/00 H05K1/03 |
| A | WU J ET AL: "Structure and Properties of PBO-PEO Diblock Copolymer Modified Epoxy", 1 January 2005 (2005-01-01), JOURNAL OF POLYMER SCIENCE, POLYMER PHYSICS EDITION, JOHN WILEY AND SONS. NEW YORK, US, PAGE(S) 1950 - 1965, XP002367969, ISSN: 0887-6266 * abstract * * page 1951, right-hand column, last paragraph - page 1964, right-hand column, paragraph 1 * | 1-10 | |
| X | WO 2006/052727 A (DOW GLOBAL TECHNOLOGIES INC [US]; VERGHESE KANDATHIL E [US]; HEARN ROB) 18 May 2006 (2006-05-18) * page 4, line 5 - page 25, line 12 * * page 30, line 11 - page 33, line 27; claims; table 3 * | 1-10 | |
| A | WO 2005/097893 A (DOW GLOBAL TECHNOLOGIES INC; UNIV MINNESOTA [US]; VERGHESE NIKHIL EAPE) 20 October 2005 (2005-10-20) * page 2, line 8 - page 9, line 17 * * page 11, line 18 - page 12, line 5; claim 13 * | 1-10 | TECHNICAL FIELDS SEARCHED (IPC) C08J C08L |
| A | WO 2004/108826 A (DOW GLOBAL TECHNOLOGIES INC; UNIV MINNESOTA [US]; BATES FRANK S [US];) 16 December 2004 (2004-12-16) * page 2, line 20 - page 5, line 16 * * page 11, line 6 - page 21, line 25; claims 17-23 * | 1-10 | |

-/--

The present search report has been drawn up for all claims

| Place of search | Date of completion of the search | Examiner |
|---|---|---|
| Munich | 11 May 2016 | Otegui Rebollo, Juan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 16 15 1525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2008/001705 A (TORAY INDUSTRIES [JP]; SAKATA HIROAKI [JP]; TOMIOKA NOBUYUKI [JP]; HON) 3 January 2008 (2008-01-03)<br>* paragraphs [0001], [0007] - [0084], [0093] - [0101]; claims; examples *<br>& EP 2 036 950 A (TORAY INDUSTRIES [JP]) 18 March 2009 (2009-03-18)<br>* paragraphs [0001], [0007] - [0084], [0098] - [0105]; claims; examples *<br>----- | 1-10 | |
| X,P | WO 2009/018193 A (DOW GLOBAL TECHNOLOGIES INC [US]; VERGHESE KANDATHIL EAPEN [US]; PHAM) 5 February 2009 (2009-02-05)<br>* paragraphs [0001], [0010] - [0119]; claims 19-25 *<br>----- | 1-10 | |
| A | 29: "Carbon-Graphite Filaments"<br>In: KATZ H S: "HANDBOOK OF FILLERS AND REINFORCEMEMENTS FOR PLASTICS",<br>1978, VAN NOSTRAND REINHOLD, NEW YORK, US,<br>XP002757519,<br>ISBN: 0-442-25372-9<br>pages 562-582,<br>* the whole document *<br>----- | 1-10 | |

TECHNICAL FIELDS
SEARCHED    (IPC)

The present search report has been drawn up for all claims

| Place of search | Date of completion of the search | Examiner |
|---|---|---|
| Munich | 11 May 2016 | Otegui Rebollo, Juan |

EPO FORM 1503 03.82 (P04C01)

## ANNEX TO THE EUROPEAN SEARCH REPORT
## ON EUROPEAN PATENT APPLICATION NO.

EP 16 15 1525

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2016

| Patent document cited in search report | | | Publication date | Patent family member(s) | | | Publication date |
|---|---|---|---|---|---|---|---|
| US 2008015305 | A1 | | 17-01-2008 | NONE | | | |
| WO 2006052727 | A | | 18-05-2006 | AT | 453688 | T | 15-01-2010 |
| | | | | BR | PI0516702 | A | 16-09-2008 |
| | | | | CA | 2582360 | A1 | 18-05-2006 |
| | | | | CN | 101056933 | A | 17-10-2007 |
| | | | | EP | 1814948 | A1 | 08-08-2007 |
| | | | | ES | 2337598 | T3 | 27-04-2010 |
| | | | | HK | 1112930 | A1 | 03-09-2010 |
| | | | | JP | 5248860 | B2 | 31-07-2013 |
| | | | | JP | 2008519886 | A | 12-06-2008 |
| | | | | KR | 20070084111 | A | 24-08-2007 |
| | | | | RU | 2007121650 | A | 20-12-2008 |
| | | | | TW | I400296 | B | 01-07-2013 |
| | | | | US | 2008213489 | A1 | 04-09-2008 |
| | | | | WO | 2006052727 | A1 | 18-05-2006 |
| WO 2005097893 | A | | 20-10-2005 | AT | 421984 | T | 15-02-2009 |
| | | | | BR | PI0508158 | A | 04-09-2007 |
| | | | | CA | 2558819 | A1 | 20-10-2005 |
| | | | | CN | 101027358 | A | 29-08-2007 |
| | | | | CN | 101613518 | A | 30-12-2009 |
| | | | | EP | 1735379 | A1 | 27-12-2006 |
| | | | | ES | 2320906 | T3 | 29-05-2009 |
| | | | | HK | 1101699 | A1 | 31-07-2009 |
| | | | | JP | 5698324 | B2 | 08-04-2015 |
| | | | | JP | 2007530771 | A | 01-11-2007 |
| | | | | JP | 2014025068 | A | 06-02-2014 |
| | | | | KR | 20070012661 | A | 26-01-2007 |
| | | | | KR | 20110137394 | A | 22-12-2011 |
| | | | | US | 2008287595 | A1 | 20-11-2008 |
| | | | | WO | 2005097893 | A1 | 20-10-2005 |
| WO 2004108826 | A | | 16-12-2004 | CN | 1833001 | A | 13-09-2006 |
| | | | | EP | 1639043 | A2 | 29-03-2006 |
| | | | | JP | 5763576 | B2 | 12-08-2015 |
| | | | | JP | 2006527278 | A | 30-11-2006 |
| | | | | JP | 2012158760 | A | 23-08-2012 |
| | | | | KR | 20060028399 | A | 29-03-2006 |
| | | | | KR | 20120064718 | A | 19-06-2012 |
| | | | | SG | 174631 | A1 | 28-10-2011 |
| | | | | TW | I337614 | B | 21-02-2011 |
| | | | | US | 2004247881 | A1 | 09-12-2004 |
| | | | | WO | 2004108826 | A2 | 16-12-2004 |
| WO 2008001705 | A | | 03-01-2008 | CN | 101501132 | A | 05-08-2009 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 16 15 1525

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2016

| Patent document cited in search report | Publication date | Patent family member(s) | | Publication date |
|---|---|---|---|---|
| | | CN | 102604333 A | 25-07-2012 |
| | | EP | 2036950 A1 | 18-03-2009 |
| | | JP | 5382258 B2 | 08-01-2014 |
| | | JP | 5401790 B2 | 29-01-2014 |
| | | JP | 2013224448 A | 31-10-2013 |
| | | KR | 20090024825 A | 09-03-2009 |
| | | TW | 200808895 A | 16-02-2008 |
| | | US | 2009198012 A1 | 06-08-2009 |
| | | WO | 2008001705 A1 | 03-01-2008 |
| WO 2009018193 A | 05-02-2009 | BR | PI0813201 A2 | 23-12-2014 |
| | | CN | 101772546 A | 07-07-2010 |
| | | EP | 2176348 A1 | 21-04-2010 |
| | | JP | 5336485 B2 | 06-11-2013 |
| | | JP | 2010535278 A | 18-11-2010 |
| | | KR | 20100065293 A | 16-06-2010 |
| | | KR | 20150063590 A | 09-06-2015 |
| | | TW | 200918597 A | 01-05-2009 |
| | | US | 2010197848 A1 | 05-08-2010 |
| | | WO | 2009018193 A1 | 05-02-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4925901 A

**Non-patent literature cited in the description**

- **L. R. WHITTINGTON.** *Whittington's Dictionary of Plastics,* 1968, 239

- In Nonionic Surfactants Polyoxyalkylene Block Co-polymers. **WHITMARSH, R. H.** Surfactant Science Series. Marcel Dekker, 1996, vol. 60